(19) Europäisches Patentamt
European Patent Office
Office européen des brevets

(11) **EP 4 256 291 B1**

(12) **FASCICULE DE BREVET EUROPEEN**

(45) Date de publication et mention
de la délivrance du brevet:
**15.10.2025 Bulletin 2025/42**

(21) Numéro de dépôt: **21819149.2**

(22) Date de dépôt: **03.12.2021**

(51) Classification Internationale des Brevets (IPC):
**G01J 3/12** *(2006.01)* **G02F 1/11** *(2006.01)*
**G01R 23/163** *(2006.01)*

(52) Classification Coopérative des Brevets (CPC):
**G01J 3/1256; G01R 23/163; G02F 1/11**

(86) Numéro de dépôt international:
**PCT/EP2021/084245**

(87) Numéro de publication internationale:
**WO 2022/122594 (16.06.2022 Gazette 2022/24)**

(54) **DISPOSITIF D'ANALYSE SPECTRALE LARGE BANDE D'UN SIGNAL D'INTÉRÊT**

VORRICHTUNG ZUR BREITBANDIGEN SPEKTRALANALYSE EINES SIGNALS

DEVICE FOR WIDE-BAND SPECTRAL ANALYSIS OF A SIGNAL OF INTEREST

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **07.12.2020 FR 2012783**

(43) Date de publication de la demande:
**11.10.2023 Bulletin 2023/41**

(73) Titulaires:
• **Centre National de la Recherche Scientifique
75016 Paris (FR)**
• **Université Grenoble Alpes
38400 Saint-Martin-d'Hères (FR)**

(72) Inventeur: **GUILLET DE CHATELLUS, Hugues
38402 SAINT MARTIN D'HERES (FR)**

(74) Mandataire: **IPAZ
Bâtiment Platon
Parc Les Algorithmes
91190 Saint-Aubin (FR)**

(56) Documents cités:
**CN-A- 110 022 176**

• **GUILLET DE CHATELLUS HUGUES ET AL:
"Optical real-time Fourier transformation with
kilohertz resolutions", vol. 3, no. 1, 22 December
2015 (2015-12-22), pages 1, XP055832034,
Retrieved from the Internet <URL:https://www.
osapublishing.org/DirectPDFAccess/
8B836479-B8BE-4D9A-8C6F
F5E2DD85F487_333875/optica-3-1-1.pdf?da=1&
id=333875&seq=0&mobile=no> DOI: 10.1364/
OPTICA.3.000001**
• **GUILLET DE CHATELLUS H. ET AL: "Real-Time
Fourier Transformation with kHz Resolution",
OPTICS AND PHOTONICS NEWS 27 (12), 51-51, 1
December 2016 (2016-12-01), XP055832036,
Retrieved from the Internet <URL:https://www.
osapublishing.org/DirectPDFAccess/
17220032-907A-4641-97CA1F65549C
B92A_437544/opn-27-12-51.pdf?da=1&
id=437544&seq=0&mobile=no> [retrieved on
20210813]**
• **SCHNÉBELIN CÔME ET AL: "Agile photonic
fractional Fourier transformation of optical and
RF signals", vol. 4, no. 8, 28 July 2017
(2017-07-28), pages 907, XP055832101, Retrieved
from the Internet <URL:https://www.
osapublishing.org/DirectPDFAccess/
854EE24B-FD9D-42AE-A2D
DAF1782F30999_370232/optica-4-8-907.pdf?
da=1&id=370232&seq=0&mobile=no> DOI:
10.1364/OPTICA.4.000907**

EP 4 256 291 B1

- **BOSCH V DURAN ET AL: "Self-heterodyne and dual-comb spectroscopy using acousto-optic frequency combs", 2018 CONFERENCE ON LASERS AND ELECTRO-OPTICS (CLEO), OSA, 13 May 2018 (2018-05-13), pages 1 - 2, XP033380467**
- **DURAN V ET AL: "Coherent multi-heterodyne spectroscopy using acousto-optic frequency combs", ARXIV.ORG, CORNELL UNIVERSITY LIBRARY, 201 OLIN LIBRARY CORNELL UNIVERSITY ITHACA, NY 14853, 20 March 2018 (2018-03-20), XP081224448, DOI: 10.1364/ OE.26.013800**

**Description**

<u>Domaine technique</u> :

L'invention relève du domaine du traitement analogique de signaux optiques et radiofréquences, et plus particulièrement du traitement analogique de signaux optiques et radiofréquences large bande à l'aide de cavités optiques à décalage de fréquence.

<u>Technique antérieure</u> :

La connaissance du spectre d'un signal d'intérêt est primordiale dans de nombreuses applications telles que la spectrométrie, la compatibilité électromagnétique, la localisation d'émetteurs et l'interception de signaux, la navigation, et l'observation géophysique et astronomique.

Dans le domaine optique, l'analyse spectrale est typiquement réalisée par trois types de dispositifs.

Une première solution consiste à faire diffracter le signal optique par un réseau. L'éclairement en champ lointain donne le spectre. Ces spectromètres à réseau sont très utilisés, à cause de leur simplicité et leur faible coût. En revanche, leur résolution fréquentielle n'est pas meilleure que la dizaine de GHz.

Une autre technique permettant une résolution spectrale meilleure (quelques GHz) est l'analyse spectrale à transformée de Fourier (TF) qui consiste à utiliser un interféromètre de Michelson. Le retard de l'interféromètre varie au cours du temps, grâce à un miroir monté sur un chariot mobile. On enregistre les franges au cours du temps (c'est-à-dire l'interférogramme). Une opération de TF permet ensuite d'accéder au spectre. C'est le principe de base des OSA ("optical spectrum analyzer") commerciaux. Les limites de ce dispositif sont doubles : la résolution spectrale est donnée par la différence de marche maximale de l'interféromètre. En pratique, cette résolution est de l'ordre du GHz. De plus le temps nécessaire pour mesurer un spectre est de l'ordre de la seconde. La technique est donc réservée à des signaux optiques suffisamment longs, ou dont le spectre est constant au cours du temps. En effet, la probabilité d'interception ou POI (c'est à dire la probabilité qu'un signal soit effectivement mesuré par l'analyseur spectral) d'un tel dispositif est faible.

Une troisième technique est l'analyse spectrale hétérodyne. Cette technique présente une résolution spectrale de quelques MHz et permet de mesurer des spectres avec une haute résolution. Il s'agit d'utiliser un laser continu de faible largeur de raie (sub MHz), et à le balayer en fréquence. L'amplitude du battement hétérodyne à une fréquence donnée de ce laser avec le signal optique à analyser au cours de la rampe de fréquence fournit donc le spectre de ce dernier. Cependant, cette technique est coûteuse, nécessite un laser de référence, et possède une POI faible.

Dans le domaine des signaux radiofréquence (RF), les solutions commerciales actuelles d'analyse spectrale de signaux RF sont de deux sortes : les analyseurs de spectre temps-réel, et les analyseurs à balayage.

L'analyseur à balayage fonctionne en comparant (hétérodynage) le SUT (« signal under test ») avec un signal de référence dont on fait varier la fréquence au cours du temps (par exemple par une rampe de fréquence). Il permet de mesurer des largeurs spectrales supérieures à 20 GHz. Cependant, à cause de la durée de la rampe de fréquence, cette technique ne détecte, à un instant donné, qu'une très faible partie du spectre. Pour l'analyseur à balayage, le POI est typiquement de 1 %. Il n'est donc pas adapté à l'analyse de signaux brefs ou dont le spectre varie au cours du temps.

Les analyseurs temps-réel combinent une étape d'acquisition du signal, appelée conversion analogique-numérique - et une étape de calcul numérique (transformée de Fourier). La première étape est particulièrement critique pour la fidélité du processus : il faut en effet échantillonner le SUT, deux fois plus rapidement que sa fréquence maximale (critère de Nyquist). Un taux d'échantillonnage trop faible se traduit donc par une perte de l'information des hautes fréquences du SUT. Or, la fréquence d'échantillonage des convertisseurs analogiques-numériques est intrinsèquement limitée à quelques Gech/s. Par conséquent, les meilleurs analyseurs de spectre en temps réel ne permettent pas d'atteindre des largeurs spectrales supérieures au GHz. Ils mobilisent par ailleurs des ressources informatiques très importantes pour effectuer le calcul du spectre en temps réel. DURAN V ET AL: "Coherent multi-heterodyne spectroscopy using acousto-optic frequency combs", ARXIV.ORG, CORNELL UNIVERSITY LIBRARY, 201 OLINE LIBRARY CORNELL UNIVERSITY ITHACA, NY 14853, 20 mars 2018 divulgue de l'art antérieur.

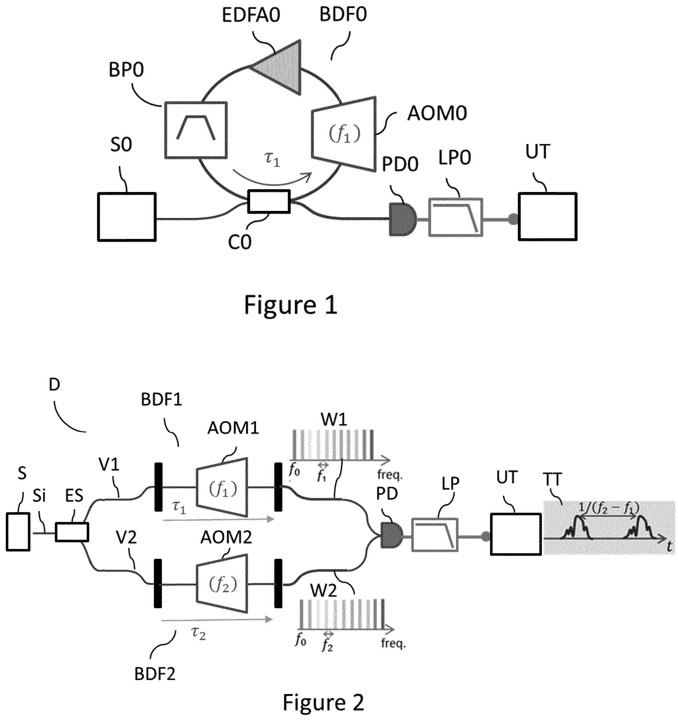

Par ailleurs, le document « Hugues Guillet de Chatellus, Luis Romero Cortés, and José Azaña. "Optical real-time Fourier transformation with kilohertz resolutions." *Optica* 3.1 (2016): 1-8 », décrit un dispositif comprenant une boucle à décalage de fréquence dans laquelle on injecte un signal d'intérêt. Le dispositif décrit dans ce document permet de générer en sortie un signal temporel reproduisant le spectre du signal d'entrée, à condition que $f_1\tau_1$ soit un entier avec $f_1$ la fréquence de décalage du signal d'intérêt par aller-retour dans la boucle et $\tau_1$ la durée d'un aller-retour du signal d'intérêt dans la boucle. La figure 1 représente schématiquement le dispositif décrit dans le document précité. Le dispositif comprend une source S0 générant un signal optique ou un signal RF porté par (c'est-à-dire modulé en amplitude par) un signal optique, de manière à former un signal d'intérêt. Par « porté par » on entend ici et dans la suite du document que le signal porteur est modulé en amplitude par le signal modulant. Ce signal d'intérêt est injecté dans la boucle à décalage de fréquence BDF0 fibrée par le biais d'un coupleur fibré C0. La boucle BDF0 comprend un décaleur de fréquence AOM0 (par exemple un modulateur acousto optique) adapté pour décaler la fréquence optique du signal d'une fréquence $f_1$ par aller-retour dans la boucle. La boucle BDF0 comprend de plus un amplificateur EDFA0 (par exemple un amplificateur à fibre dopé comme un EDFA, pour Erbium Doped Fiber Amplifier) pour compenser les pertes induites par la boucle et un filtre optique passe-bande BP0 pour limiter le bruit provenant de l'émission spontanée amplifiée de l'amplificateur et pour fixer le nombre d'aller-retour dans la boucle. Le rayonnement transmis par la boucle est détecté par une photodiode PD0 générant un photocourant qui est filtré par un filtre passe bas analogique LP0 adapté pour garder uniquement des fréquences du photocourant inférieures à la fréquence de Nyquist du signal d'intérêt. Un processeur UT est configuré pour calculer le module carré du photocourant. Lorsque $f_1\tau_1$ est un entier, la trace temporelle obtenue après traitement du photocourant par le processeur est le spectre de puissance du signal optique dans le cas où le signal d'intérêt est un signal optique ou le spectre de puissance du signal RF dans le cas où le signal d'intérêt est un signal RF porté par un signal optique cohérent.

Ce système présente des limitations technologiques importantes. Tout d'abord la largeur spectrale du signal d'intérêt doit être inférieure à $1/\tau_1$ (soit de l'ordre de 10 MHz), ce qui limite fortement les applications pratiques. Ici, il n'est pas possible d'augmenter $\tau_1$ de façon à atteindre une bande passante de l'ordre de la dizaine de GHz, à cause de la complexité et les pertes par propagation que cela entrainerait. L'autre contrainte est que la période du signal de sortie (le spectre) vaut $1/f_1$, ce qui oblige à échantillonner le signal de sortie à $Nf_1$, c'est-à-dire à quelques dizaines de Géch/s (en prenant N = 300 et $f_1$ = 80 MHz).

Par ailleurs, le dispositif de l'art antérieur de la figure 1 permet de calculer la transformée de Fourier fractionnaire d'un signal d'intérêt lorsque $f_1\tau_1$ est proche d'un entier. Cette propriété est décrite dans le document : Côme Schnébelin and Hugues Guillet de Chatellus, "Agile photonic fractional Fourier transformation of optical and RF signals," Optica 4, 907-910 (2017). La transformée de Fourier fractionnaire (TFFr) est une généralisation de la transformée de Fourier (TF) à tout domaine intermédiaire (dit fractionnaire) entre l'espace direct et l'espace de Fourier. Cette transformation peut s'apparenter à une rotation dans le domaine temps-fréquence. En écrivant la transformation de Fourier classique d'une fonction $f$ sous la forme $F_{\frac{\pi}{2}}(f)$ on peut généraliser cette écriture pour n'importe quel ordre fractionnaire $\alpha$. La Transformation de Fourier fractionnaire (TFFr) d'ordre $\alpha$ de sera donc : $F_\alpha(f)$. La TFFr est pertinente pour analyser des signaux d'entrée dont la fréquence varie linéairement avec le temps (signaux à modulation linéaire de fréquence, ou « chirps »).

Pour $\alpha = 0$, on trouve l'opérateur identité et le résultat donnerait la fonction *f*. Pour $\alpha = \pi/2$, on trouve la transformation de Fourier classique. Pour $\alpha \in \mathbb{R}$ et avec $u$ la variable dans le domaine d'arrivée appelé domaine fractionnaire, la *TFFr* d'ordre $\alpha$ de la fonction *f* peut s'exprimer sous la forme :

$$F_\alpha[f(x)](u) = \sqrt{1 - i\cot(\alpha)}\, e^{i\pi \cot(\alpha)u^2} \int_{-\infty}^{+\infty} e^{-i2\pi(\csc(\alpha)ux - \frac{\cot(\alpha)}{2}x^2)} f(x)dx$$

L'invention vise à pallier certains des problèmes précités de l'art antérieur en proposant un dispositif d'analyse spectral d'un signal d'intérêt large bande mettant en œuvre deux cavités en décalage de fréquence

### Résumé de l'invention :

A cet effet, un objet de l'invention est un dispositif large bande d'analyse spectrale d'un signal d'intérêt comprenant :

- une source adaptée pour générer ledit signal d'intérêt;

- un élément optique séparateur adapté pour séparer spatialement ledit signal d'intérêt en un premier signal et un deuxième signal ;

- une première cavité optique à décalage de fréquence comprenant un premier décaleur de fréquence adapté pour décaler la fréquence optique du premier signal d'une première fréquence $f_1$ par aller-retour dans ladite première cavité, ladite première cavité présentant un premier temps de parcours $\tau_1$ ;

- une deuxième cavité optique à décalage de fréquence comprenant un deuxième décaleur de fréquence adapté pour décaler la fréquence optique du deuxième signal d'une deuxième fréquence $f_2$ par aller-retour dans ladite deuxième cavité, ladite deuxième cavité présentant un deuxième temps de parcours $\tau_2$ ;

- la première et la deuxième cavité optique étant adaptées pour qu'un nombre maximal d'aller-retour dudit signal dans la première et la deuxième cavité soit égal à N prédéterminé ;

- un détecteur adapté pour détecter de manière cohérente le premier signal transmis par la première cavité et le deuxième signal transmis par la deuxième cavité et générer un photocourant proportionnel à une intensité lumineuse détectée par ledit détecteur,

- un filtre passe-bas adapté pour filtrer des fréquences du photocourant inférieures à $\min\left(\frac{f_1}{2};\frac{f_2}{2}\right)$,

- un processeur configuré pour calculer un module carré du photocourant filtré par ledit filtre passe-bas, à partir duquel est déterminée une représentation temporelle d'une information fréquentielle dudit signal d'intérêt.

Selon des modes particuliers de l'invention :

- ladite source comprend un laser continu monochromatique, une source RF adaptée pour générer un signal RF *s(t),* et un modulateur adapté pour moduler en amplitude ou en phase, par ledit signal RF *s(t),* un rayonnement laser généré par ledit laser continu, de manière à former ledit signal d'intérêt ;

- la première cavité et la deuxième cavité sont configurées pour vérifier la condition $f_1 \times \tau_1 \neq f_2 \times \tau_2$, ladite information fréquentielle étant alors une partie réelle d'une transformée de Fourier fractionnaire dudit signal d'intérêt, un ordre de ladite transformée de Fourier fractionnaire étant fixé par la valeur $f_1 \times \tau_1$ - $f_2 \times \tau_2$ ;

- première cavité et la deuxième cavité sont configurées pour vérifier la condition $f_1 \times \tau_1 = f_2 \times \tau_2$ modulo 1, ladite information fréquentielle étant alors un spectre de puissance dudit signal d'intérêt ;

- le filtre passe-bas analogique est adapté pour filtrer des fréquences dudit photocourant inférieures à min[ $N \times |f_1$ - $f_2|$ ; $f_1/2$ ; $f_2/2$] ;

- la première et la deuxième cavité comprennent respectivement un premier et un deuxième amplificateur adaptés pour compenser les pertes induites respectivement par la première et la deuxième cavité,

- le premier décaleur de fréquence est un premier modulateur acousto-optique excité par un premier oscillateur local adapté pour faire varier ladite première fréquence de décalage et dans lequel le deuxième décaleur de fréquence est un deuxième modulateur acousto-optique excité par un deuxième oscillateur local adapté pour faire varier ladite deuxième fréquence de décalage ;

- la première cavité comprend une première ligne à retard contrôlable et adaptée pour faire varier le premier temps de parcours $\tau_1$ et dans lequel la deuxième cavité comprend une deuxième ligne à retard contrôlable et adaptée pour faire varier le deuxième temps de parcours $\tau_2$ ;

- la première et la deuxième cavité sont des cavités fibrées en anneau comprenant respectivement un premier et un deuxième amplificateur à fibre dopé et un premier et un deuxième filtres optiques passe-bande configurés pour fixer ledit nombre maximal N d'aller-retour dans la première et la deuxième cavité ;

- le dispositif comprend des moyens de stabilisation de la première et de la deuxième cavité adaptés pour maintenir au cours du temps la cohérence dudit premier signal transmis par la première cavité avec ledit deuxième signal transmis par la deuxième cavité ;

- le dispositif comprenant une cavité unique en anneau, ledit dispositif comprenant en outre :

  • un premier coupleur adapté pour injecter ledit premier signal dans ladite cavité unique selon un premier sens,
  • un deuxième coupleur adapté pour injecter ledit deuxième signal dans ladite cavité unique selon un deuxième sens,

  ladite première cavité correspondant à la cavité unique dans laquelle le premier signal est injecté selon le premier sens d'injection,

  ladite deuxième cavité correspondant à la cavité unique dans laquelle le deuxième signal est injecté selon le deuxième sens d'injection.

ladite cavité unique en anneau comprenant :

- un premier circulateur adapté pour diriger le premier signal vers une première ligne à retard contrôlable et adaptée pour faire varier le premier temps de parcours $\tau_1$ et comprenant ledit premier décaleur de fréquence,
- un deuxième circulateur adapté pour diriger le deuxième signal vers une deuxième ligne à retard contrôlable et adaptée pour faire varier le deuxième temps de parcours $\tau_1$ comprenant ledit deuxième décaleur de fréquence,
- un amplificateur à fibre dopé,
- un filtre optique passe bande configuré pour fixer ledit nombre maximal N d'aller-retour,

- la première et la deuxième cavité sont configurées pour que $\dfrac{1}{|\tau_1 - \tau_2|} \geq 40\, GHz$ ;

- la première et la deuxième cavité sont configurés pour que N soit supérieur à 200 ;

Un autre objet de l'invention est une méthode d'analyse spectrale d'un signal d'intérêt utilisant une première cavité optique à décalage de fréquence comprenant un premier décaleur de fréquence présentant un premier temps de parcours $\tau_1$ et une deuxième cavité optique à décalage de fréquence comprenant un deuxième décaleur de fréquence présentant un deuxième temps de parcours $\tau_2$, un nombre maximal d'aller-retour dudit signal d'intérêt dans la première et la deuxième cavité étant égal à N prédéterminé, ladite méthode comprenant les étapes suivantes :

A. générer ledit signal d'intérêt ;

B. séparer spatialement ledit signal d'intérêt en un premier signal et un deuxième signal ;

C. injecter ledit premier signal dans la première cavité optique à décalage de fréquence et décaler la fréquence optique du premier signal d'une première fréquence $f_1$ par aller-retour dans ladite première cavité ;

D. injecter ledit deuxième signal dans la deuxième cavité optique à décalage de fréquence et décaler la fréquence optique du deuxième signal d'une deuxième fréquence $f_2$ par aller-retour dans ladite deuxième cavité;

E. détecter de manière cohérente le premier signal transmis par la première cavité et le deuxième signal transmis par la deuxième cavité et générer un photocourant proportionnel à une intensité lumineuse détectée,

F. filtrer des fréquences du photocourant inférieures à $\min\left(\dfrac{f_1}{2} ; \dfrac{f_2}{2}\right)$,

G. calculer un module carré du photocourant filtré et déterminer une représentation temporelle d'une information fréquentielle dudit signal d'intérêt

Selon des modes particuliers de la méthode de l'invention :

- la méthode comprend une étape antérieure à l'étape A, notée étape A0 consistant à ajuster la première ou la deuxième cavité afin de fixer la différence $f_1 \times \tau_1 - f_2 \times \tau_2$ sur une valeur non nulle souhaitée, afin de calculer, dans l'étape G, un ordre spécifique d'une partie réelle d'une transformée de Fourier fractionnaire du signal d'intérêt,

- la méthode comprend une étape antérieure à l'étape A, notée étape A0 consistant à ajuster la première ou la deuxième cavité afin d'annuler la différence $f_1 \times \tau_1 - f_2 \times \tau_2$, afin de calculer, dans l'étape G, un spectre de puissance dudit signal d'intérêt.

**Brève description des figures** :

D'autres caractéristiques, détails et avantages de l'invention ressortiront à la lecture de la description faite en référence aux dessins annexés donnés à titre d'exemple et qui représentent, respectivement :

La figure 1, une vue schématique d'un dispositif d'analyse spectrale de l'art antérieur,

La figure 2, une vue schématique d'un dispositif d'analyse spectrale de large bande selon l'invention,

La figure 3, une vue schématique d'un dispositif d'analyse spectrale large bande selon un premier mode de réalisation l'invention

La figure 4, une vue schématique d'un dispositif d'analyse spectrale large bande selon un troisième mode de réalisation l'invention

La figure 5, une vue schématique d'un dispositif d'analyse spectrale large bande selon un quatrième mode de réalisation l'invention

La figure 6, méthode d'analyse spectrale selon l'invention

Les références aux figures, quand elles sont identiques, correspondent aux mêmes éléments.

Dans les figures, sauf contre-indication, les éléments ne sont pas à l'échelle.

## Description détaillée:

La figure 2 est une représentation schématique d'un dispositif D d'analyse spectrale large bande d'un signal d'intérêt selon l'invention. Comme cela sera précisé plus loin, grâce à une première cavité optique à décalage de fréquence BDF1 et une deuxième cavité optique à décalage de fréquence BDF2 le dispositif D de l'invention permet de déterminer une représentation temporelle d'une information fréquentielle du signal d'intérêt. Selon certaines conditions liant ces cavités, cette représentation temporelle de l'information fréquentielle est la partie réelle d'une transformée fractionnaire ou un spectre de puissance du signal d'intérêt.

Par « large bande », on entend ici que la bande passante du dispositif est supérieure ou égale à 20 GHz, préférentiellement supérieure ou égale à 40 GHz. Les paramètres contrôlant la bande passante du dispositif seront précisés plus loin dans la description.

Le dispositif D de l'invention comprend une source S de rayonnement adaptée pour générer le signal d'intérêt Si. Un élément optique séparateur ES du dispositif est adapté pour séparer spatialement le signal d'intérêt en un premier signal V1 et un deuxième signal V2.

Selon un mode de réalisation, le trajet optique du signal d'intérêt à la sortie de la source S est fibré et l'élément ES est un coupleur fibré 1x2 (aussi appelé coupleur en Y). Alternativement, selon un autre mode de réalisation, le trajet optique du signal d'intérêt à la sortie de la source S est en espace libre et l'élément séparateur ES est une lame séparatrice ou un cube séparateur.

Le premier signal V1 est injecté dans la première cavité optique à décalage de fréquence BDF1. Cette cavité BDF1 présente un premier temps de parcours $\tau_1$ (temps d'aller-retour dans la cavité) et comprend un premier décaleur de fréquence AOM1 adapté pour décaler la fréquence optique du premier signal d'une première fréquence $f_1$ par aller-retour dans la première cavité.

De manière similaire, le deuxième signal V2 est injecté dans la deuxième cavité optique à décalage de fréquence BDF2 qui présente un deuxième temps de parcours $\tau_2$ et qui comprend un deuxième décaleur de fréquence AOM2 adapté pour décaler la fréquence optique du deuxième signal d'une deuxième fréquence $f_2$ par aller-retour dans la deuxième cavité.

La première cavité optique BDF1 et la deuxième cavité optique BDF2 peuvent être indifféremment et sans sortir du cadre de l'invention une cavité linéaire ou une cavité en anneau, et une cavité en espace libre ou une cavité fibrée.

De manière essentielle, la première et la deuxième cavité optique sont adaptées pour qu'un nombre maximal d'aller-retour du signal dans la première et la deuxième cavité soit égal à un nombre $N$ prédéterminé. Ainsi, en appelant $f_0$, la fréquence centrale du signal d'intérêt, la première et la deuxième cavité génèrent chacune un peigne de fréquences comprenant respectivement les fréquences $f_0 + n \times f_1$ et $f_0 + n \times f_2$, avec $n \in [1; N]$. Concrètement, la première et la deuxième cavité produisent des répliques du signal d'intérêt, décalées à la fois temporellement (de multiples de $\tau_1$ et $\tau_2$ respectivement), et en fréquence (de multiples de $f_1$ et $f_2$ respectivement).

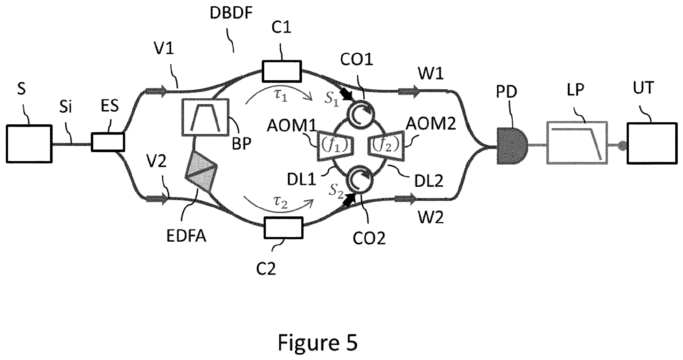

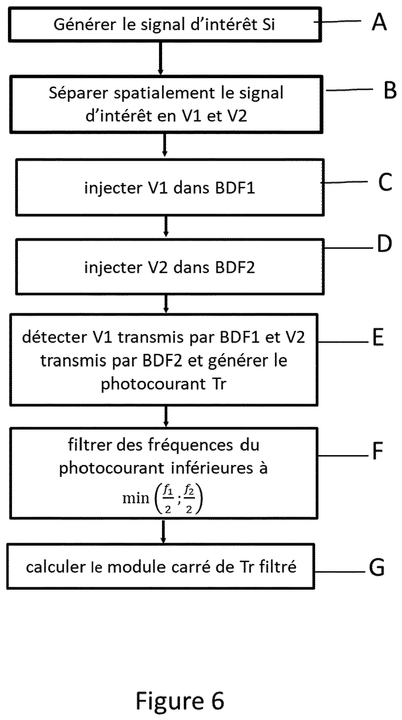

Selon un mode de réalisation, afin de contrôler ce nombre maximal d'aller-retour N, la première et la deuxième boucle comprennent respectivement un premier et un deuxième filtre passe bande BP1, BP2 (non représenté en figure 2 mais visibles en figures 5 et 6), de largeur de bande adaptée pour transmettre respectivement les fréquences $f_0 + n \times f_1$ et $f_0 + n \times f_2$, avec $n \in [1; N]$.

Le premier décaleur de fréquence AOM1 et le second décaleur de fréquence AOM2 sont préférentiellement des modulateurs acousto-optiques contrôlés par un premier OL1 et un deuxième oscillateur local OL2 (non représenté dans les figures). La fréquence d'excitation générée par le premier oscillateur local et le deuxième oscillateur local permet de faire varier la première fréquence $f_1$ et la deuxième fréquence $f_2$. Alternativement, le premier et le second décaleur de fréquence sont des modulateurs électro-optiques à bande latérale unique (ou SSB MZM, pour single sideband Mach Zehnder modulator).

Le dispositif D comprend en outre un détecteur PD adapté pour détecter de manière cohérente le premier signal W1 transmis par la première cavité et le deuxième signal W2 transmis par la deuxième cavité. Le détecteur PD est typiquement une photodiode ou tout autre photodétecteur connu de l'homme de l'art. De préférence le détecteur PD est formé par des photodiodes balancées afin de détecter de très faibles variations de signal lumineux.

Ce détecteur PD détecte en temps réel une intensité lumineuse qui correspond à la sommation cohérente de toutes les répliques du signal d'intérêt décalées à la fois temporellement, et en fréquence (les peines de fréquences) par la première et la deuxième cavité et génère alors un photocourant Tr proportionnel à cette intensité lumineuse détectée. Pour que le dispositif fonctionne, il est essentiel que le premier signal W1 transmis par BDF1 soit cohérent avec le signal W2 transmis par BDF2.

Le photocourant Tr est alors filtré par un filtre analogique passe-bas LP adapté pour laisser passer des fréquences du photocourant inférieures aux fréquences de Nyquist associées au premier signal W1 et au second signal W2, c'est-à-dire min($f_1/2$ ; $f_2/2$)

Enfin, le dispositif D comprend un processeur UT configuré pour calculer un module carré du photocourant filtré par le filtre LP, générant ainsi une trace temporelle TT. Par le biais de cette trace TT, le dispositif D permet de déterminer une représentation temporelle d'une information fréquentielle du signal d'intérêt.

Dans le dispositif D de l'invention, la bande passante est égale à $LS_{in}$ = 1/($\tau_1$ - $\tau_2$). Cette caractéristique est très intéressante car en minimisant la différence $\tau_1$ - $\tau_2$, il est possible de maximiser la bande passante du dispositif D.

Les inventeurs ont démontré que, selon la valeur de la différence $f_1 \times \tau_1$ - $f_2 \times \tau_2$, la trace TT est la partie réelle de la transformée de Fourier fractionnaire ou un spectre de puissance du signal d'intérêt. Dans un souci de clarté, le développement des équations explicitant ce résultat sont présenté à la fin de la présente description

Ainsi, selon une première variante de l'invention, la première cavité et la deuxième cavité sont configurées pour vérifier la condition $f_1 \times \tau_1$ = $f_2 \times \tau_2$ (modulo 1). Dans cette première variante, le photocourant Tr est une représentation temporelle de la partie réelle de la transformée de Fourier du signal d'intérêt ($\alpha$ = $\pi/2$) et la trace TT est alors une représentation temporelle du spectre de puissance de ce signal. Le dispositif D permet donc de réaliser une cartographie du spectre au cours du temps (Frequency-to-time mapping) en temps réel.

De manière préférentielle, dans cette première variante, le filtre passe-bas analogique LP est adapté pour filtrer des fréquences du photocourant inférieures à une valeur min[ $N \times |f_1 - f_2|$ ; $f_1/2$ ; $f_2/2$)], avant le calcul du module carré du photocourant par le processeur UT. Le filtrage des fréquences inférieures à $N \times |f_1 - f_2|$ permet, si cette valeur est inférieure aux fréquences de Nyquist $f_1/2$ ; $f_2/2$ , de traiter le photocourant Tr avec un processeur comprenant une électronique de traitement plus lente (typiquement 50 Méch/s).

Dans cette première variante, la résolution fréquentielle du dispositif vaut $\Delta_f$ = 1/($N(\tau_1$ - $\tau_2$)) = $LS_{in}$/$N$. Ainsi, on comprend que, afin d'obtenir une résolution spectrale $\Delta_f$ convenable tout en conservant une bande passante $LS_{in}$ élevée, il faut maximiser le nombre d'aller-retour maximal dans la première et la deuxième cavité BDF1, BDF2. De manière préférentielle, afin d'obtenir une résolution spectrale convenable, la première et la deuxième cavité sont configurés pour qu'un nombre maximal d'aller-retour maximal $N$ soit supérieur à 200, préférentiellement supérieur à 500. Typiquement, pour une bande passante de $LS_{in}$ = 20GHz, et N=400 la résolution fréquentielle du dispositif vaut $\Delta_f$ = *50MHz.*

Dans une deuxième variante de l'invention, la première cavité et la deuxième cavité sont configurées pour vérifier la condition $f_1 \times \tau_1 \neq f_2 \times \tau_2$ , modulo 1. Cette différence doit être très inférieure à 1, c'est-à-dire que : $f_1\tau_1$ = $f_2\tau_2$ +$\varepsilon$, ($|\varepsilon|$ « 1 (voir équations en fin de description). Dans cette deuxième variante, la trace TT est alors une représentation temporelle de la partie réelle de la transformée de Fourier fractionnaire (TFFr) du signal d'intérêt. L'ordre de la transformée fractionnaire représentée par le dispositif D est fixée par la différence $f_1 \times \tau_1$ - $f_2 \times \tau_2$. Plus précisément, lorsque $f_1 \times \tau_1$ = $f_2 \times \tau_2$ modulo 1, (première variante de l'invention), le photocourant est une représentation temporelle de partie réelle de la transformée de Fourier du signal d'entrée (c'est-à-dire ordre de la TFFr correspondant à $\pi/2$) alors que alors que lorsque $f_1 \times \tau_1$ - $f_2 \times \tau_2$ a une valeur proche de 0 (deuxième variante), le photocourant représente la partie réelle de la TFFr du signal d'intérêt. Concrètement, l'ordre de la TFFr dépend du facteur d'échelle ($f_2$ - $f_1$)/($\tau_1$ - $\tau_2$) (voir les équations en fin de description).

Dans cette deuxième variante de l'invention, il est possible de définir une résolution fréquentielle en considérant deux signaux à modulation linéaire de fréquence, simultanés, et ayant le même taux de chirp (c'est-à-dire la même pente dans le plan temps-fréquence). Ces deux signaux diffèrent donc par la fréquence de départ. En choisissant le bon ordre de la TFFr, la TFFr de ces signaux chirpés consiste en deux pics, dont l'espacement est proportionnel à l'écart de fréquence entre ces deux signaux chirpés. La résolution du dispositif dans la deuxième variante de l'invention correspond alors à la plus petite valeur de la fréquence d'écart entre les deux chirps mesurable par le dispositif. Cette définition permet de définir une résolution pour ce système qui soit une fréquence.

Ainsi, selon la valeur de la différence $f_1 \times \tau_1$ - $f_2 \times \tau_2$, le dispositif D de l'invention permet d'obtenir une représentation temporelle en temps réel de deux informations fréquentielles différentes du signal d'intérêt : la partie réelle de la TFFr ou le spectre de puissance.

La résolution temporelle du dispositif (c'est à dire le temps que met le système à calculer et produire l'information fréquentielle) est égale à $1/(f_2 - f_1)$. On note que les informations fréquentielles sont obtenues en temps réel, c'est-à-dire que l'information fréquentielle déterminée est actualisée toute les périodes $1/(f_2 - f_1)$.

Selon un mode de réalisation, la première cavité comprend une première ligne à retard DL1 (non représenté) contrôlable et adaptée pour faire varier le premier temps de parcours $\tau_1$ et/ou la deuxième cavité comprend une première ligne à retard DL2 (non représenté) contrôlable et adaptée pour faire varier le deuxième temps de parcours $\tau_2$. Ainsi, il est possible de réduire la différence $(\tau_1 - \tau_2)$ afin de maximiser la bande passante $LS_{in}$ du dispositif D. De manière préférentielle, la différence $(\tau_1 - \tau_2)$ est telle que la bande passante $LS_{in}$ est supérieure ou égale à 20 GHz, préférentiellement supérieure ou égale à 40 GHz. Cette valeur de bande passante n'est pas atteignable dans le dispositif décrit dans le document « de Chatellus, Hugues Guillet, Luis Romero Cortés, and José Azaña. "Optical real-time Fourier transformation with kilohertz resolutions." Optica 3.1 (2016): 1-8 », où la bande passante du dispositif est de l'ordre de 10 MHz car fixée par $1/\tau_1$.

Un avantage des modes de réalisation de l'invention comprenant des lignes à retard DL1, DL2 et/ou des décaleurs à fréquence AOM1, AOM2 qui permettent de faire varier $f_1$ et $f_2$ est de permettre le contrôle de la différence $f_1 \times \tau_1 - f_2 \times \tau_2$. Ainsi, il est possible de faire basculer le fonctionnement du dispositif de la première variante de l'invention vers la deuxième variante de l'invention ou vice-versa. En outre, le contrôle de la différence $f_1 \times \tau_1 - f_2 \times \tau_2$ permet de choisir l'ordre de la TFFr du signal d'intérêt.

On note que dans les modes de réalisation de l'invention dans lesquels la première et la deuxième cavité BDF1, BDF2 comprennent respectivement un premier et deuxième filtre passe bande BP1, BP2, la bande passante $LS_{in}$ est égale à une largeur spectrale $LS_{BP}$ du premier et du deuxième filtre passe bande lorsque cette largeur spectrale $LS_{BP}$ est inférieure à $1/(\tau_1 - \tau_2)$. En d'autres termes, la bande passante est égale à $LS_{in} = min(1/(\tau_1 - \tau_2) \; ; LS_{BP})$.

De manière notable, le dispositif D n'effectue aucune troncature ou prélèvement sur le spectre du signal d'intérêt réduisant la partie du spectre analysée. Ainsi, à l'inverse de certains des dispositifs de l'art antérieurs évoqués précédemment, le dispositif D de l'invention présente une POI de 100% et l'information fréquentielle du signal d'intérêt représentée par la trace TT est représentative de la totalité du spectre du signal d'intérêt comprise dans la bande passante.

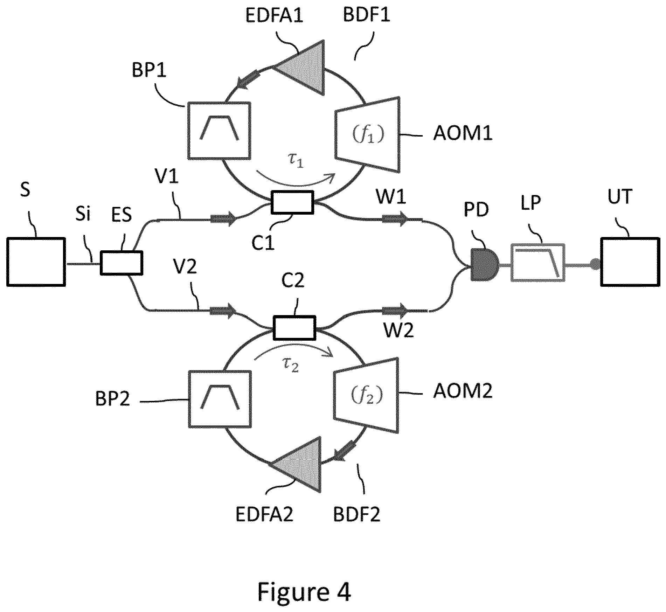

Selon un mode de réalisation, la première et la deuxième cavité comprennent respectivement un premier et un deuxième amplificateur EDFA1, EDFA2 (non représentés en figure 1 mais visibles en figure 4) adaptés pour compenser les pertes induites par la première et la deuxième cavité.

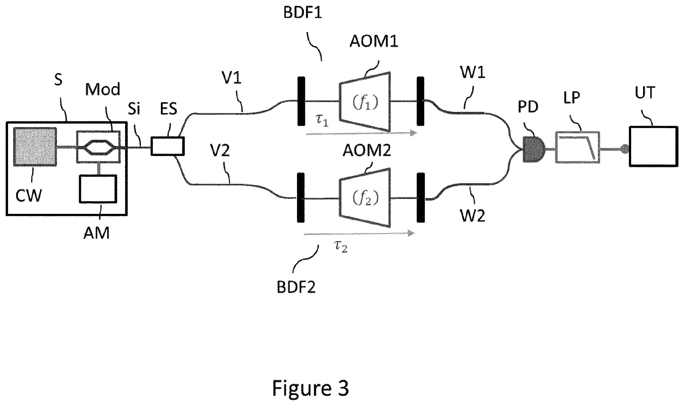

Selon un premier mode de réalisation de l'invention, illustré en figure 3, la source S comprend un laser continu CW monochromatique, une source RF AM adaptée pour générer un signal RF $s(t)$, et un modulateur Mod adapté pour moduler en amplitude ou en phase, par le signal RF $s(t)$, le rayonnement laser généré par le laser continu de manière à former ledit signal d'intérêt. Dans le premier mode de réalisation de l'invention, le dispositif D permet de déterminer une représentation temporelle d'une information fréquentielle du signal RF $s(t)$ porté par le laser continu. Ainsi, selon la deuxième variante de l'invention, la trace TT est alors une représentation temporelle de la TFFr du signal RF $s(t)$ et selon la première variante de l'invention, la trace TT est alors une représentation temporelle du produit de convolution du spectre de puissance du laser CW monochromatique, par le spectre de puissance du signal RF $s(t)$. Lorsque le laser CW a un temps de cohérence suffisamment long pour que le rayonnement reste cohérent au sein des cavités BDF1, BDF2 (typiquement de l'ordre de la centaine de μs), alors la trace TT est alors une représentation temporelle de la partie réelle du spectre du signal RF s(t). Ce premier mode de réalisation est particulièrement intéressant compte tenu de la bande passante $LS_{in}$ du dispositif qui peut être supérieure à 40 GHz tout en ayant une POI de 100%, ces valeurs n'étant pas inatteignables par les dispositifs de l'art antérieur réalisant l'analyse spectrale de signaux RF.

Dans un deuxième mode de réalisation, la source S est une source optique cohérente générant un signal d'intérêt Si sous la forme d'un rayonnement lumineux $s(t)$, par exemple une source laser. Dans le deuxième mode de réalisation de l'invention, le dispositif D permet de déterminer une représentation temporelle d'une information fréquentielle du signal $s(t)$.

La figure 4 illustre schématiquement un troisième mode de réalisation, compatible avec le premier et le second mode de réalisation, dans lequel la totalité du trajet optique du signal d'intérêt depuis la source jusqu'à la détection par la photodiode est fibré. L'alignement du dispositif est ainsi simplifié et le dispositif est moins sensible aux chocs et aux vibrations. Dans ce troisième mode de réalisation, le signal d'intérêt Si est séparé, par un coupleur en Y ES, de manière à former le premier signal V1 et le second signal V2, tous les deux guidés dans une fibre optique respective. La première et la deuxième cavité BDF1, BDF2 sont des cavités fibrées en anneau comprenant respectivement un premier et un deuxième amplificateur à fibre dopé EDFA1, EDFA2 et un premier et un deuxième filtres optiques passe-bande BP1, BP2. Le premier signal V1 est injecté dans la première cavité BDF1 par le biais d'un coupleur fibré C1 et le deuxième signal V2 est injecté dans la deuxième cavité BDF2 par le biais d'un coupleur fibré C2.

Comme expliqué précédemment, le premier et le deuxième amplificateur à fibre dopé EDFA1, EDFA2, par exemple des EDFA, sont adaptés pour compenser les pertes induites dans les cavités BDF1, BDF2. Les filtres optiques passe-bande BP1, BP2 sont configurés pour fixer ledit nombre N d'aller-retour maximal dans la première et la deuxième cavité et pour limiter le bruit provenant de l'émission spontanée amplifiée des amplificateurs à fibre dopé.

Avantageusement, dans le troisième mode de réalisation, le dispositif D comprend des moyens de stabilisation ST (non représenté) de la première et de la deuxième cavité BDF1, BDF2 adaptés pour maintenir au cours du temps la cohérence entre le premier signal transmis par la première cavité et le deuxième signal transmis par la deuxième cavité. Le dispositif de stabilisation permet d'assurer que les rayonnements transmis par les deux cavités BDF1, BDF2 soient mutuellement cohérent. Un tel dispositif est bien connu de l'homme de l'art et est par exemple décrit dans Coherent multi-heterodyne spectroscopy using acousto-optic frequency combs," Opt. Express 26, 13800-13809 (2018).

La figure 5 illustre schématiquement un quatrième mode de réalisation, compatible avec le premier et le second mode de réalisation, qui constitue une alternative au troisième mode de réalisation. Ce quatrième mode de réalisation vise à s'affranchir du problème du maintien au cours du temps de la cohérence entre le premier signal W1 et le deuxième signal W2 transmis par la première et la deuxième cavité. Pour cela le dispositif comprend une cavité unique en anneau fibrée BDF configurée pour former la première et la deuxième cavité BDF1, BDF2 selon le sens d'injection. Cette configuration à une seule cavité en anneau contra-propageante, permet de limiter les effets des fluctuations de longueur de fibres (vibrations, dérives thermiques...) qui peuvent être différentes entre la première et la deuxième cavité du troisième mode de réalisation, et qui entraînent une perte de cohérence au fur et à mesure des aller-retour. Elle permet aussi de réduire le nombre de composants optiques nécessaires.

De manière similaire au troisième mode de réalisation, dans le dispositif D du quatrième mode de réalisation, la totalité du trajet optique du signal d'intérêt depuis la source jusqu'à la détection par la photodiode est fibrée. Le dispositif D comprend un premier coupleur fibré C1 adapté pour injecter le premier signal V1 dans la cavité unique BDF selon un premier sens $S_1$. De plus, le dispositif D comprend un deuxième coupleur fibré C2 adapté pour injecter le deuxième signal V2 dans la cavité unique BDF selon un deuxième sens $S_2$. La cavité BDF comprend :

- un premier circulateur CO1 adapté pour diriger le premier signal V1 vers une première ligne à retard DL1 comprenant le premier décaleur de fréquence AOM1.
- un deuxième circulateur CO2 adapté pour diriger le deuxième signal vers la deuxième ligne à retard DL2 comprenant le deuxième décaleur de fréquence AOM2,
- un amplificateur à fibre dopé EDFA bi-directionnel (fonctionnant dans les deux sens),
  un filtre optique passe bande BP configuré pour fixer ledit nombre maximal N d'aller-retours. Ainsi, la première cavité BDF1 correspond à la cavité unique BDF dans laquelle le premier signal V1 est injecté selon le premier sens d'injection $S_1$ et la deuxième cavité BDF2 correspond à la cavité unique BDF dans laquelle le deuxième signal V2 est injecté selon le deuxième sens d'injection $S_2$.

Alternativement, selon une variante du quatrième mode de réalisation, au lieu d'un unique amplificateur EDFA et un unique filtre optique passe bande BP commun au premier signal V1 et au deuxième signal V2, la première ligne à retard DL1 comprend un premier amplificateur EDFA1 et un optique passe bande BP1 et la deuxième ligne à retard DL1 comprend un deuxième amplificateur EDFA2 et un optique passe bande BP2.

Il est entendu que les modes de réalisation des figures 3 à 5 sont compatibles avec la première et la deuxième variante de l'invention selon la valeur de la différence $f_1 \times \tau_1 - f_2 \times \tau_2$.

Un autre objet de l'invention est une méthode d'analyse spectrale d'un signal d'intérêt Si mise en œuvre par le dispositif D de l'invention. La figure 6 illustre schématiquement cette méthode qui permet une représentation temporelle d'une information fréquentielle (TFFr ou spectre de puissance) du signal d'intérêt en fonction de la valeur de la différence $f_1 \times \tau_1 - f_2 \times \tau_2$.

La méthode de la figure 6 comprend les étapes suivantes :

A. générer le signal d'intérêt Si ;

B. séparer spatialement le signal d'intérêt en le premier signal V1 et le deuxième signal V2 ;

C. injecter le premier signal dans la première cavité optique à décalage de fréquence BDF1 et décaler la fréquence optique du premier signal d'une première fréquence $f_1$ par aller-retour dans la première cavité ;

D. injecter le deuxième signal dans la deuxième cavité optique à décalage de fréquence BDF2 décaler la fréquence optique du deuxième signal d'une deuxième fréquence $f_2$ par aller-retour dans la deuxième cavité;

E. détecter de manière cohérente le premier signal transmis W1 par la première cavité et le deuxième signal transmis W2 par la deuxième cavité et générer le photocourant Tr proportionnel à l'intensité lumineuse détectée,

F. filtrer des fréquences du photocourant inférieures à $\min\left(\frac{f_1}{2};\frac{f_2}{2}\right)$,

G. calculer le module carré du photocourant filtré à partir duquel est déterminée une représentation temporelle d'une information fréquentielle dudit signal d'intérêt.

La méthode de la figure 6 possède l'avantage notable d'être large-bande, de présenter un POI de 100% et une bonne résolution fréquentielle.

Selon une première variante de la méthode de la figure 6, la méthode comprend une étape antérieure à l'étape A), notée étape A0) consistant ajuster la première ou la deuxième cavité afin d'annuler la différence $f_1 \times \tau_1 - f_2 \times \tau_2$, de manière à calculer, dans l'étape G, un spectre de puissance du signal d'intérêt. Cette première variante est mise en œuvre par la première variante du dispositif de l'invention.

Selon une deuxième variante de la méthode de la figure 6, la méthode comprend une étape antérieure à l'étape A), notée étape A0) consistant ajuster la première ou la deuxième cavité afin de fixer la différence $f_1 \times \tau_1 - f_2 \times \tau_2$ sur une valeur non nulle souhaitée, afin de calculer, dans l'étape G, un ordre spécifique de la partie réelle d'une transformée de Fourier fractionnaire du signal d'intérêt. Cette deuxième variante est mise en œuvre par la deuxième variante du dispositif de l'invention.

Les équations démontrant que, selon la valeur de la différence $f_1 \times \tau_1 - f_2 \times \tau_2$, la trace TT est la partie réelle une transformée de Fourier fractionnaire ou un spectre de puissance du signal d'intérêt sont développées ci-après

On note $f_0$ la fréquence du laser d'injection, $\tau_1$, $\tau_2$ les temps de parcours dans les boucles, $f_1$, $f_2$ les fréquences de décalage par tour et $s(t)$ le signal d'intérêt.

Les champs électriques en sortie de la première et la deuxième cavité valent respectivement :

$$E_1(t) = \sum_{n=0}^{N} s(t - n\tau_1) E_0 e^{i2\pi f_0 t} e^{i2\pi n f_1 t} e^{-i\pi f_1 \tau_1 n^2} \qquad (1)$$

$$E_2(t) = \sum_{n=0}^{N} s(t - n\tau_2) E_0 e^{i2\pi f_0 t} e^{i2\pi n f_2 t} e^{-i\pi f_2 \tau_2 n^2} \qquad (2)$$

L;intensité détectée par PD vaut:

$$I(t) = w(t) * E_1(t) E_2^*(t) \qquad (3)$$

où $w(t)$ est une fenêtre temporelle centrée en t (liée à la réponse de la détection) et $*$ est le produit de convolution. En omettant le terme $E_0 E_0^*$, on a

$$I(t) = w(t) * \sum_{n,m} s(t - n\tau_1) s(t - m\tau_2) e^{i2\pi(nf_1 - mf_2)t} e^{-i\pi(f_1\tau_1 n^2 - f_2\tau_2 m^2)} \qquad (4)$$

$$I(t) = \qquad (5)$$
$$\int w(t - t') \sum_{n,m} s(t' - n\tau_1) s(t' - m\tau_2) e^{i2\pi(nf_1 - mf_2)t'} e^{-i\pi(f_1\tau_1 n^2 - f_2\tau_2 m^2)} \, dt'$$

On choisit les fréquences $f_1$ et $f_2$ telle que $\Delta f = f_2 - f_1 \leq f_1/2N, f_2/2N$. La durée de la fenêtre $w(t)$ est choisie de l'ordre de $1/N\Delta f$. Elle est donc supérieure à $2/f_1$ et $2/f_1$. Ainsi, seules les paires d'entier ($n, m = n$)ont une contribution non-nulle dans l'intégrale.

**Première variante de l'invention** :

On suppose ici que $f_1\tau_1 = f_2\tau_2$. On a alors :

$$I(t) = \int w(t - t') \sum_n s(t' - n\tau_1) s(t' - n\tau_2) e^{-i2\pi n\Delta f t'} \, dt' \qquad (6)$$

Sur la durée de la fenêtre, $e^{-i2\pi n\Delta f t'}$ peut être assimilé à $e^{-i2\pi n\Delta f t}$ car la durée de la fenêtre est plus courte que la période des fonctions $e^{-i2\pi n\Delta f t'}$.

On a ainsi:

$$I(t) = \sum_n e^{-i2\pi n\Delta ft} \int w(t-t')s(t'-n\tau_1)s(t'-n\tau_2) \; dt' \tag{7}$$

$$I(t) = \sum_n < s(t-n\tau_1)s(t-n\tau_2) > e^{-i2\pi n\Delta ft} \tag{8}$$

où <> représente la moyenne mesurée sur la durée de la fenêtre.

En faisant un décalage de l'origine des temps, on a

$$I(t) = \sum_n < s(t)s(t-n\Delta\tau) > e^{-i2\pi n\Delta ft} \tag{9}$$

où $\Delta\tau = \tau_2 - \tau_1$. On définit la fonction de corrélation à l'instant *t* pour le retard *T* : *C(t, T)* =< *s(t)s(t - T)* >.

Soit

$$I(t) = \sum_n C(t, n\Delta\tau) \; e^{-i2\pi n\Delta ft} \tag{10}$$

On écrit, en définissant $\delta(t)$ comme la fonction delta de Dirac :

$$I(t) = \sum_n \int C(t,t') \; e^{-i2\pi\frac{\Delta f}{\Delta\tau}t't}\delta(t'-n\Delta\tau)dt' =$$

$$\int C(t,t')e^{-i2\pi\frac{\Delta f}{\Delta\tau}t't}\sum_n e^{i2\pi n\frac{t'}{\Delta\tau}} \, dt' = \sum_n \int C(t,t') \; e^{-i2\pi\left(\frac{\Delta f}{\Delta\tau}t-\frac{n}{\Delta\tau}\right)t'}dt' \tag{11}$$

et finalement :

$$I(t) = \sum_n \tilde{C}\left(t, \frac{\Delta f}{\Delta\tau}t - \frac{n}{\Delta\tau}\right) \tag{12}$$

où $\tilde{C}(t, f) = \int C(t, t') \, e^{-i2\pi ft'}dt'$ est la transformée de Fourier (TF) de $C(t, t')$ par rapport à la variable *t'*.

*I(t)* est donc une répétition de la TF de la fonction d'autocorrélation à l'instant t projetée dans le temps, c'est à dire, par le théorème de Wiener-Khintchine, le spectre de puissance du signal d'entrée à l'instant t. On note ici que le signal effectivement mesuré par le détecteur PD est en réalité 2*Re(I(t))*. Le spectre de puissance s'obtient via une transformation de Hilbert du signal mesuré.

La période du signal de sortie est 1/$\Delta f$. On retrouve donc le spectre du signal d'entrée projeté dans le domaine temporel ("frequency-to-time mapping"). Le coefficient de proportionnalité est simplement $\Delta\tau/\Delta f = (f_2 - f_1)/(\tau_1 - \tau_2)$.

La résolution temporelle est donnée par la durée de la fenêtre w(t), c'est à dire de l'ordre de 1/$N\Delta f$. Par conséquent, la résolution spectrale est: $\delta f = \frac{\Delta f}{\Delta\tau}\frac{1}{N\Delta f} = \frac{1}{N\Delta\tau}$

La largeur spectrale de *s(t)* mesurable sans ambiguïté est 1/$\Delta\tau$.

On note ce résultat est valable lorsque pour tout $f_1\tau_1 = f_2\tau_2$ modulo 1 (voir équation 5). Par modulo 1, on entend ici $f_1\tau_1 = f_2\tau_2 + k,$ avec $k \in \mathbb{N}$.

**Deuxième variante de l'invention** :

On suppose à présent que : $f_1\tau_1 = f_2\tau_2 + \varepsilon$, ($|\varepsilon| \ll 1$) on a:

$$I(t) = \sum_n C(t, n\Delta\tau) \; e^{-i2\pi n\Delta ft}e^{-i\pi\varepsilon n^2} \tag{13}$$

En suivant la même démarche :

$$I(t) = \sum_n \int C(t,t') \; e^{-i2\pi\frac{\Delta f}{\Delta\tau}t't} e^{-i\pi\varepsilon\frac{t'^2}{\Delta\tau^2}} \delta(t' - n\Delta\tau)dt' \qquad (14)$$

$$= \int \mathcal{C}(t,t')e^{-i2\pi\frac{\Delta f}{\Delta\tau}t't} e^{-i\pi\varepsilon\frac{t'^2}{\Delta\tau^2}} \sum_n e^{i2\pi n\frac{t'}{\Delta\tau}} \; dt'$$

$$= \sum_n \int \mathcal{C}(t,t') \; e^{-i2\pi\left(\frac{\Delta f}{\Delta\tau}t - \frac{n}{\Delta\tau}\right)t'} e^{-i\pi\varepsilon\frac{t'^2}{\Delta\tau^2}} dt'$$

Pour faire apparaître une TF fractionnaire, on pose $y = t'/\Delta\tau$. On obtient donc :

$$I(t) \propto \sum_n \int C(t,y) \; e^{-i2\pi(\Delta f t - n)y} e^{-i\pi\varepsilon y^2} \; dy \qquad (15)$$

On reconnaît l'expression de la TF fractionnaire (TFFr) de la fonction C (hormis un terme de phase quadratique qui serait en $e^{i\beta t^2}$). Ici, l'ordre $\alpha$ de la TFFr est donné par : $\cot\alpha = 2\pi\varepsilon$. On note que la définition de paramètre $y$ définit ici l'ordre de la TFFr.

Finalement, $I(t)$ est donc la répétition de la TFFr de la fonction d'autocorrélation à l'instant t projetée dans le temps, c'est à dire, par le théorème de convolution appliqué à la TFFr, le module carré de la TFFr du signal d'entrée.

Comme précédemment, le signal effectivement mesuré par le détecteur est en réalité $2Re(I(t))$, ce qui fait que le module carré de la TFFr s'obtient via une transformation de Hilbert du signal mesuré.

La période du signal de sortie est $1/\Delta f$. On retrouve donc la TFFr du signal d'entrée projeté dans le domaine temporel ("fractional frequency-to-time mapping").

## Revendications

1. Dispositif large bande d'analyse spectrale (D) d'un signal d'intérêt comprenant :

   - une source (S) adaptée pour générer ledit signal d'intérêt (Si) ;
   - un élément optique séparateur (ES) adapté pour séparer spatialement ledit signal d'intérêt en un premier signal (V1) et un deuxième signal (V2) ;
   - une première cavité optique à décalage de fréquence (DBDF, BDF1) comprenant un premier décaleur de fréquence (AOM1) adapté pour décaler la fréquence optique du premier signal d'une première fréquence $f_1$ par aller-retour dans ladite première cavité, ladite première cavité présentant un premier temps de parcours $\tau_1$ ;
   - une deuxième cavité optique à décalage de fréquence (DBDF, BDF2) comprenant un deuxième décaleur de fréquence (AOM2) adapté pour décaler la fréquence optique du deuxième signal d'une deuxième fréquence $f_2$ par aller-retour dans ladite deuxième cavité, ladite deuxième cavité présentant un deuxième temps de parcours $\tau_2$ ;
   la première et la deuxième cavité optique étant adaptées pour qu'un nombre maximal d'aller-retour dudit signal dans la première et la deuxième cavité soit égal à N prédéterminé ;
   - un détecteur (PD) adapté pour détecter de manière cohérente le premier signal (W1) transmis par la première cavité et le deuxième signal (W2) transmis par la deuxième cavité et générer un photocourant (Tr) proportionnel à une intensité lumineuse détectée par ledit détecteur,

   - un filtre passe-bas (LP) adapté pour filtrer des fréquences du photocourant inférieures à $\min\left(\frac{f_1}{2}; \frac{f_2}{2}\right)$,

   - un processeur (UT) configuré pour calculer un module carré du photocourant filtré par ledit filtre passe-bas, à partir duquel est déterminée une représentation temporelle d'une information fréquentielle dudit signal d'intérêt, ladite information fréquentielle étant :

     ∘ une partie réelle d'une transformée de Fourier fractionnaire dudit signal d'intérêt, un ordre de ladite transformée de Fourier fractionnaire étant fixé par la valeur $f_1 \times \tau_1 - f_2 \times \tau_2$ lorsque la première cavité et la deuxième cavité sont configurées pour vérifier la condition $f_1 \times \tau_1 \neq f_2 \times \tau_2$, modulo 1 ou

○ un spectre de puissance dudit signal d'intérêt lorsque la première cavité et la deuxième cavité sont configurées pour vérifier la condition $f_1 \times \tau_1 = f_2 \times \tau_2$ modulo 1.

2. Dispositif selon la revendication 1, dans lequel ladite source comprend un laser continu (CW) monochromatique, une source RF (AM) adaptée pour générer un signal RF $s(t)$, et un modulateur (Mod) adapté pour moduler en amplitude ou en phase, par ledit signal RF $s(t)$, un rayonnement laser généré par ledit laser continu, de manière à former ledit signal d'intérêt.

3. Dispositif selon la revendication 1 ou 2, dans lequel le filtre passe-bas (LP) analogique est adapté pour filtrer des fréquences dudit photocourant inférieures à min[ $N \times |f_1 - f_2|$ ; $f_1/2$ ; $f_2/2$]., lorsque la première cavité et la deuxième cavité sont configurées pour vérifier la condition $f_1 \times \tau_1 = f_2 \times \tau_2$ modulo 1.

4. Dispositif selon l'une quelconque des revendications précédentes, dans lequel la première et la deuxième cavité comprennent respectivement un premier et un deuxième amplificateur (EDFA, EDFA1, EDFA2) adaptés pour compenser les pertes induites respectivement par la première et la deuxième cavité.

5. Dispositif selon l'une quelconque des revendications précédentes, dans lequel le premier décaleur de fréquence est un premier modulateur acousto-optique excité par un premier oscillateur local (OL1) adapté pour faire varier ladite première fréquence de décalage et dans lequel le deuxième décaleur de fréquence est un deuxième modulateur acousto-optique excité par un deuxième oscillateur local (OL2) adapté pour faire varier ladite deuxième fréquence de décalage.

6. Dispositif selon l'une quelconque des revendications précédentes, dans lequel la première cavité comprend une première ligne à retard (DL1) contrôlable et adaptée pour faire varier le premier temps de parcours $\tau_1$ et dans lequel la deuxième cavité comprend une deuxième ligne à retard (DL2) contrôlable et adaptée pour faire varier le deuxième temps de parcours $\tau_2$.

7. Dispositif selon l'une quelconque des revendications précédentes, dans lequel la première et la deuxième cavité sont des cavités fibrées en anneau (BDF1, BDF2) comprenant respectivement un premier et un deuxième amplificateur à fibre dopé (EDFA1, EDFA2) et un premier et un deuxième filtres optiques passe-bande (BP1, BP2) configurés pour fixer ledit nombre maximal N d'aller-retour dans la première et la deuxième cavité.

8. Dispositif selon la revendication précédente, comprenant des moyens de stabilisation (ST) de la première et de la deuxième cavité adaptés pour maintenir au cours du temps la cohérence dudit premier signal transmis par la première cavité avec ledit deuxième signal transmis par la deuxième cavité.

9. Dispositif selon la revendication 6, comprenant une cavité unique en anneau (BDF), ledit dispositif comprenant en outre :

- un premier coupleur (C1) adapté pour injecter ledit premier signal (V1) dans ladite cavité unique selon un premier sens,
- un deuxième coupleur (C2) adapté pour injecter ledit deuxième signal (V2) dans ladite cavité unique selon un deuxième sens,
ladite première cavité correspondant à la cavité unique dans laquelle le premier signal est injecté selon le premier sens d'injection,
ladite deuxième cavité correspondant à la cavité unique dans laquelle le deuxième signal est injecté selon le deuxième sens d'injection.
ladite cavité unique en anneau comprenant :

○ un premier circulateur (CO1) adapté pour diriger le premier signal vers une première ligne à retard (DL1) contrôlable et adaptée pour faire varier le premier temps de parcours $\tau_1$ et comprenant ledit premier décaleur de fréquence (AOM1),
○ un deuxième circulateur (CO2) adapté pour diriger le deuxième signal vers une deuxième ligne à retard (DL2) contrôlable et adaptée pour faire varier le deuxième temps de parcours $\tau_1$ comprenant ledit deuxième décaleur de fréquence (AOM2),
○ un amplificateur à fibre dopé (EDFA),
○ un filtre optique passe bande (BP) configuré pour fixer ledit nombre maximal N d'aller-retour,

**10.** Dispositif selon l'une quelconque des revendications précédentes, dans lequel la première et la deuxième cavité sont configurées pour que $\frac{1}{|\tau_1-\tau_2|} \geq 40\,GHz$.

**11.** Dispositif selon l'une quelconque des revendications précédentes, dans lequel la première et la deuxième cavité sont configurés pour que N soit supérieur à 200.

**12.** Méthode d'analyse spectrale d'un signal d'intérêt (Si) utilisant une première cavité optique à décalage de fréquence (BDF1) comprenant un premier décaleur de fréquence (AOM1) présentant un premier temps de parcours $\tau_1$ et une deuxième cavité optique à décalage de fréquence (BDF2) comprenant un deuxième décaleur de fréquence (AOM2) présentant un deuxième temps de parcours $\tau_2$, un nombre maximal d'aller-retour dudit signal d'intérêt dans la première et la deuxième cavité étant égal à N prédéterminé, ladite méthode comprenant les étapes suivantes :

    A. générer ledit signal d'intérêt ;
    B. séparer spatialement ledit signal d'intérêt en un premier signal (V1) et un deuxième signal (V2) ;
    C. injecter ledit premier signal dans la première cavité optique à décalage de fréquence (BDF1) et décaler la fréquence optique du premier signal d'une première fréquence $f_1$ par aller-retour dans ladite première cavité ;
    D. injecter ledit deuxième signal dans la deuxième cavité optique à décalage de fréquence (BDF2) et décaler la fréquence optique du deuxième signal d'une deuxième fréquence $f_2$ par aller-retour dans ladite deuxième cavité;
    E. détecter de manière cohérente le premier signal transmis par la première cavité (W1) et le deuxième signal transmis (W2) par la deuxième cavité et générer un photocourant (Tr) proportionnel à une intensité lumineuse détectée,
    F. filtrer des fréquences du photocourant inférieures à $\min\left(\frac{f_1}{2};\frac{f_2}{2}\right)$,
    G. calculer un module carré du photocourant filtré et déterminer une représentation temporelle d'une information fréquentielle dudit signal d'intérêt.

ladite méthode comprenant une étape antérieure à l'étape A, notée étape A0 consistant à :

    • ajuster la première ou la deuxième cavité afin de fixer une différence $f_1 \times \tau_1 - f_2 \times \tau_2$ sur une valeur non nulle souhaitée, afin de calculer, dans l'étape G, un ordre spécifique d'une partie réelle d'une transformée de Fourier fractionnaire du signal d'intérêt, ou
    • ajuster la première ou la deuxième cavité afin d'annuler une différence $f_1 \times \tau_1 - f_2 \times \tau_2$, afin de calculer, dans l'étape G, un spectre de puissance dudit signal d'intérêt.

**Patentansprüche**

**1.** Breitbandvorrichtung zur Spektralanalyse (D) eines Signals von Interesse, umfassend:

    - eine Quelle (S), die zum Erzeugen des Signals (Si) von Interesse ausgelegt ist;
    - ein optisches Trennelement (ES), das dazu ausgelegt ist, das Signal von Interesse räumlich in ein erstes Signal (V1) und ein zweites Signal (V2) zu trennen;
    - einen ersten optischen Frequenzverschiebungsresonator (DBDF, BDF1), der einen ersten Frequenzschieber (AOM1) umfasst, der dazu ausgelegt ist, die optische Frequenz des ersten Signals um eine erste Frequenz $f_1$ durch Hin- und Rücklauf in dem ersten Resonator zu verschieben, wobei der erste Resonator eine erste Laufzeit $\tau_1$ aufweist;
    - einen zweiten optischen Frequenzverschiebungsresonator (DBDF, BDF2), der einen zweiten Frequenzschieber (AOM2) umfasst, der dazu ausgelegt ist, die optische Frequenz des zweiten Signals um eine zweite Frequenz $f_2$ durch Hin- und Rücklauf in dem zweiten Resonator zu verschieben, wobei der zweite Resonator eine zweite Laufzeit $\tau_2$ aufweist;
    wobei der erste und der zweite optische Resonator so ausgelegt sind, dass die maximale Anzahl von Hin- und Rückläufen des Signals im ersten und zweiten Resonator gleich einem vorgegebenen Wert N ist;
    - einen Detektor (PD), der dazu ausgelegt ist, das vom ersten Resonator übertragene erste Signal (W1) und das vom zweiten Resonator übertragene zweite Signal (W2) kohärent zu erfassen und einen Fotostrom (Tr) zu erzeugen, der proportional zu einer vom Detektor erfassten Lichtintensität ist,

- einen Tiefpassfilter (LP), der zum Filtern von Fotostromfrequenzen von weniger als $\min\left(\frac{f_1}{2};\frac{f_2}{2}\right)$, ausgelegt ist,

- einen Prozessor (UT), der dazu konfiguriert ist, ein quadratisches Modul des durch den Tiefpassfilter gefilterten Fotostroms zu berechnen, aus dem eine zeitliche Darstellung von Frequenzinformationen des Signals von Interesse bestimmt wird, wobei es sich bei den Frequenzinformationen um Folgendes handelt:

    ◦ einen realen Teil einer fraktionalen Fourier-Transformation des Signals von Interesse, wobei eine Ordnung der fraktionalen Fourier-Transformation durch den Wert $f_1 \times \tau_1 - f_2 \times \tau_2$ festgelegt ist, wenn der erste und der zweite Resonator so konfiguriert sind, dass sie den Zustand $f_1 \times \tau_1 \neq f_2 \times \tau_2$, Modul 1, verifizieren, oder
    ◦ ein Leistungsspektrum des Signals von Interesse, wenn der erste und der zweite Resonator so konfiguriert sind, dass sie den Zustand $f_1 \times \tau_1 = f_2 \times \tau_2$, Modul 1, verifizieren.

2.   Vorrichtung nach Anspruch 1, wobei die Quelle einen monochromatischen Dauerlichtlaser (CW) und eine HF-Quelle (AM) umfasst, die ausgelegt ist, um ein HF-Signal s(t) zu erzeugen, und einen Modulator (Mod), der dazu ausgelegt ist, über das HF-Signal $s(t)$ eine Laserstrahlung, die von dem Dauerlichtlaser erzeugt wird, in Amplitude oder Phase zu modulieren, um das Signal von Interesse zu bilden.

3.   Vorrichtung nach Anspruch 1 oder 2, wobei der analoge Tiefpassfilter (LP) dazu ausgelegt ist, Frequenzen des Fotostroms zu filtern, die niedriger sind als min [N $\times$ |$f_1$ - $f_2$ | ; $f_1$/2 ; $f_2$/2], wenn der erste Resonator und der zweite Resonator so konfiguriert sind, dass sie den Zustand $f_1 \times \tau_1 = f_2 \times \tau_2$, Modul 1, verifizieren.

4.   Vorrichtung nach einem der vorstehenden Ansprüche, wobei der erste und der zweite Resonator jeweils einen ersten und einen zweiten Verstärker (EDFA, EDFA1, EDFA2) umfassen, die dazu ausgelegt sind, die durch den ersten bzw. den zweiten Resonator verursachten Verluste zu kompensieren.

5.   Vorrichtung nach einem der vorstehenden Ansprüche, wobei der erste Frequenzschieber ein erster akustooptischer Modulator ist, der durch einen ersten lokalen Oszillator (OL1) angeregt wird, der dazu ausgelegt ist, die erste Frequenzverschiebung zu variieren, und wobei der zweite Frequenzschieber ein zweiter akustooptischer Modulator ist, der durch einen zweiten lokalen Oszillator (OL2) angeregt wird, der dazu ausgelegt ist, die zweite Frequenzverschiebung zu variieren.

6.   Vorrichtung nach einem der vorstehenden Ansprüche, wobei der erste Resonator eine erste Verzögerungsleitung (DL1) umfasst, die steuerbar und dazu ausgelegt ist, die erste Laufzeit $\tau_1$ zu variieren, und wobei der zweite Resonator eine zweite Verzögerungsleitung (DL2) umfasst, die steuerbar und dazu ausgelegt ist, die zweite Laufzeit $\tau_2$ zu variieren.

7.   Vorrichtung nach einem der vorstehenden Ansprüche, wobei der erste und der zweite Resonator Faserringresonatoren (BDF1, BDF2) sind, die jeweils einen ersten und einen zweiten dotierten Faserverstärker (EDFA1, EDFA2) und einen ersten und einen zweiten optischen Bandpassfilter (BP1, BP2) umfassen, die so konfiguriert sind, dass sie die maximale Anzahl N von Hin- und Rückläufen im ersten und im zweiten Resonator festlegen.

8.   Vorrichtung nach dem vorstehenden Anspruch, die Stabilisierungsmittel (ST) für den ersten und den zweiten Resonator umfasst, die dazu ausgelegt sind, die Kohärenz des vom ersten Resonator übertragenen ersten Signals mit dem vom zweiten Resonator übertragenen zweiten Signal über die Zeit aufrechtzuerhalten.

9.   Vorrichtung nach Anspruch 6, die einen einzigen Ringresonator (BDF) umfasst, wobei die Vorrichtung ferner umfasst:

    - einen ersten Koppler (C1), der dazu ausgelegt ist, das erste Signal (V1) in einer ersten Richtung in den einzelnen Resonator einzuspeisen,
    - einen zweiten Koppler (C2), der dazu ausgelegt ist, das zweite Signal (V2) in einer zweiten Richtung in den einzelnen Resonator einzuspeisen,
    wobei der erste Resonator dem einzigen Resonator entspricht, in den das erste Signal entsprechend der ersten Einspeisungsrichtung eingespeist wird,
    wobei der zweite Resonator dem einzigen Resonator entspricht, in den das zweite Signal entsprechend der zweiten Einspeisungsrichtung eingespeist wird,
    wobei der einzige Ringresonator umfasst:

◦ einen ersten Zirkulator (CO1), der dazu ausgelegt ist, das erste Signal an eine erste Verzögerungsleitung (DL1) weiterzuleiten, die steuerbar ist und die dazu ausgelegt ist, die erste Laufzeit $\tau_1$ zu variieren, und den ersten Frequenzschieber (AOM1) umfasst,

◦ einen zweiten Zirkulator (CO2), der dazu ausgelegt ist, das zweite Signal an eine zweite Verzögerungsleitung (DL2) weiterzuleiten, die steuerbar ist und die dazu ausgelegt ist, die zweite Laufzeit $\tau_1$ zu variieren, und den zweiten Frequenzschieber (AOM2) umfasst,

◦ einen dotierten Faserverstärker (EDFA),

◦ einen optischen Bandpassfilter (BP), der so konfiguriert ist, dass er die maximale Anzahl N von Hin- und Rückläufen festlegt,

10. Vorrichtung nach einem der vorstehenden Ansprüche, wobei der erste und der zweite Resonator so konfiguriert sind,

dass $\frac{1}{|\tau_1 - \tau_2|} \geq 40\ GHz$.

11. Vorrichtung nach einem der vorstehenden Ansprüche, wobei der erste und der zweite Resonator so konfiguriert sind, dass N größer als 200 ist.

12. Verfahren zur Spektralanalyse eines Signals (Si) von Interesse unter Verwendung eines ersten optischen Frequenzverschiebungsresonators (BDF1), der einen ersten Frequenzschieber (AOM1) mit einer ersten Laufzeit $\tau_1$ umfasst, und eines zweiten optischen Frequenzverschiebungsresonators (BDF2), der einen zweiten Frequenzschieber (AOM2) mit einer zweiten Laufzeit $\tau_2$ umfasst, wobei die maximale Anzahl von Hin- und Rückläufen des Signals von Interesse im ersten und zweiten Resonator gleich einem vorgegebenen Wert N ist, wobei das Verfahren die folgenden Schritte umfasst:

A. Erzeugen des Signals von Interesse;

B. räumliches Trennen des Signals von Interesse in ein erstes Signal (V1) und ein zweites Signal (V2);

C. Einspeisen des ersten Signals in den ersten optischen Frequenzverschiebungsresonator (BDF1) und Verschieben der optischen Frequenz des ersten Signals um eine erste Frequenz $f_1$ durch Hin- und Rücklauf in dem ersten Resonator;

D. Einspeisen des zweiten Signals in den zweiten optischen Frequenzverschiebungsresonator (BDF2) und Verschieben der optischen Frequenz des zweiten Signals um eine zweite Frequenz $f_2$ durch Hin- und Rücklauf in dem zweiten Resonator;

E. kohärentes Erfassen des vom ersten Resonator (W1) übertragenen ersten Signals und des vom zweiten Resonator (W2) übertragenen zweiten Signals und Erzeugen eines Fotostroms (Tr), der proportional zu einer erfassten Lichtintensität ist,

F. Filtern von Fotostromfrequenzen niedriger als $\min\left(\frac{f_1}{2}; \frac{f_2}{2}\right)$,

G. Berechnen eines quadratischen Moduls des gefilterten Fotostroms und Bestimmen einer zeitlichen Darstellung der Frequenzinformationen des Signals von Interesse,

wobei das Verfahren einen Schritt vor Schritt A mit der Bezeichnung "Schritt A0" umfasst, der aus Folgendem besteht:

• Anpassen des ersten oder zweiten Resonators, um eine Differenz $f_1 \times \tau_1 = f_2 \times \tau_2$ auf einen gewünschten Wert ungleich Null festzulegen, um in Schritt G eine bestimmte Ordnung eines realen Teils einer fraktionalen Fourier-Transformation des Signals von Interesse zu berechnen, oder

• Anpassen des ersten oder zweiten Resonators, um eine Differenz $f_1 \times \tau_1 - f_2 \times \tau_2$ auszugleichen, um in Schritt G ein Leistungsspektrum des Signals von Interesse zu berechnen.

**Claims**

1. A wideband device (D) for the spectral analysis of a signal of interest comprising:

- a source (S) designed to generate said signal of interest (Si);
- an optical splitter element (ES) designed to spatially split said signal of interest into a first signal (V1) and a second signal (V2);
- a first frequency-shifting optical cavity (DBDF, BDF1) comprising a first frequency shifter (AOM1) designed to shift the optical frequency of the first signal by a first frequency $f_1$ per round trip in said first cavity, said first cavity having a first trip time $\tau_1$ ;

- a second frequency-shifting optical cavity (DBDF, BDF2) comprising a second frequency shifter (AOM2) designed to shift the optical frequency of the second signal by a second frequency $f_2$ per round trip in said second cavity, said second cavity having a second trip time $\tau_2$ ;

the first and the second optical cavity being designed such that a maximum number of round trips of said signal in the first and the second cavity is equal to predetermined N;

- a detector (PD) designed to coherently detect the first signal (W1) transmitted by the first cavity and the second signal (W2) transmitted by the second cavity and generate a photocurrent (Tr) proportional to a luminous intensity detected by said detector,

- a low-pass filter (LP) designed to filter frequencies of the photocurrent that are lower than $\min\left(\dfrac{f_1}{2};\dfrac{f_2}{2}\right)$ ,

- a processor (UT) configured to compute a square modulus of the photocurrent filtered by said low-pass filter, from which a temporal representation of frequency information of said signal of interest is determined, said frequency information being:

○ a real part of a fractional Fourier transform of said signal of interest, an order of said fractional Fourier transform being set by the value $f_1 \times \tau_1 - f_2 \times \tau_2$ when the first cavity and the second cavity are configured to verify the condition $f_1 \times \tau_1 \neq f_2 \times \tau_2$, modulo 1 or

○ a power spectrum of said signal of interest when the first cavity and the second cavity are configured to verify the condition $f_1 \times \tau_1 = f_2 \times \tau_2$ modulo 1.

2. The device as claimed in claim 1, wherein said source comprises a monochromatic continuous-wave laser (CW), an RF source (AM) designed to generate an RF signal *s(t)*, and a modulator (Mod) designed to amplitude-modulate or phase-modulate, using said RF signal *s(t)*, laser radiation generated by said continuous-wave laser, so as to form said signal of interest.

3. The device as claimed in claim 1 or 2, wherein the analog low-pass filter (LP) is designed to filter frequencies of said photocurrent that are lower than min [ $N \times |f_1 - f_2|$ ; $f_1/2$ ; $f_2/2$], when the first cavity and the second cavity are configured to verify the condition $f_1 \times \tau_1 = f_2 \times \tau_2$ modulo 1.

4. The device as claimed in any one of the preceding claims, wherein the first and the second cavity respectively comprise a first and a second amplifier (EDFA, EDFA1, EDFA2) designed to compensate for the losses induced respectively by the first and the second cavity.

5. The device as claimed in any one of the preceding claims, wherein the first frequency shifter is a first acousto-optic modulator excited by a first local oscillator (OL1) designed to vary said first shift frequency and wherein the second frequency shifter is a second acousto-optic modulator excited by a second local oscillator (OL2) designed to vary said second shift frequency.

6. The device as claimed in any one of the preceding claims, wherein the first cavity comprises a first controllable delay line (DL1) designed to vary the first trip time $\tau_1$ and wherein the second cavity comprises a second controllable delay line (DL2) designed to vary the second trip time $\tau_2$.

7. The device as claimed in any one of the preceding claims, wherein the first and the second cavity are fiber ring cavities (BDF1, BDF2) comprising respectively a first and a second doped fiber amplifier (EDFA1, EDFA2) and a first and a second optical bandpass filter (BP1, BP2) configured to set said maximum number N of round trips in the first and the second cavity.

8. The device as claimed in the preceding claim, comprising stabilizing means (ST) for stabilizing the first and the second cavity that are designed to maintain, over time, the coherence of said first signal transmitted by the first cavity with said second signal transmitted by the second cavity.

9. The device as claimed in claim 6, comprising a single ring cavity (BDF), said device furthermore comprising:

- a first coupler (C1) designed to inject said first signal (V1) into said single cavity in a first direction,
- a second coupler (C2) designed to inject said second signal (V2) into said single cavity in a second direction, said first cavity corresponding to the single cavity into which the first signal is injected in the first injection direction,

said second cavity corresponding to the single cavity into which the second signal is injected in the second injection direction,

said single ring cavity comprising:

 ◦ a first circulator (CO1) designed to direct the first signal to a first controllable delay line (DL1) designed to vary the first trip time $\tau_1$ and comprising said first frequency shifter (AOM1),
 ◦ a second circulator (CO2) designed to direct the second signal to a second controllable delay line (DL2) designed to vary the second trip time $\tau_1$ and comprising said second frequency shifter (AOM2),
 ◦ a doped fiber amplifier (EDFA),
 ◦ an optical bandpass filter (BP) configured to set said maximum number N of round trips.

10. The device as claimed in any one of the preceding claims, wherein the first and the second cavity are configured such that $\dfrac{1}{|\tau_1 - \tau_2|} \geq 40\ GHz$ .

11. The device as claimed in any one of the preceding claims, wherein the first and the second cavity are configured such that N is greater than 200.

12. A method for the spectral analysis of a signal of interest (Si) using a first frequency-shifting optical cavity (BDF1) comprising a first frequency shifter (AOM1) having a first trip time $\tau_1$ and a second frequency-shifting optical cavity (BDF2) comprising a second frequency shifter (AOM2) having a second trip time $\tau_2$, a maximum number of round trips of said signal of interest in the first and the second cavity being equal to predetermined N, said method comprising the following steps:

 A. generating said signal of interest;
 B. spatially splitting said signal of interest into a first signal (V1) and a second signal (V2);
 C. injecting said first signal into the first frequency-shifting optical cavity (BDF1) and shifting the optical frequency of the first signal by a first frequency $f_1$ per round trip in said first cavity ;
 D. injecting said second signal into the second frequency-shifting optical cavity (BDF2) and shifting the optical frequency of the second signal by a second frequency $f_2$ per round trip in said second cavity;
 E. coherently detecting the first signal transmitted by the first cavity (W1) and the second signal (W2) transmitted by the second cavity and generating a photocurrent (Tr) proportional to a detected luminous intensity,

 F. filtering frequencies of the photocurrent that are lower than $\min\left(\dfrac{f_1}{2}; \dfrac{f_2}{2}\right)$,

 G. computing a square modulus of the filtered photocurrent and determining a temporal representation of frequency information of said signal of interest,

said method comprising a step prior to step A, denoted step A0, of:

 • adjusting the first or the second cavity in order to set a difference $f_1 \times \tau_1 - f_2 \times \tau_2$ to a desired non-zero value, in order to compute, in step G, a specific order of a real part of a fractional Fourier transform of the signal of interest, or
 • adjusting the first or the second cavity in order to cancel out a difference $f_1 \times \tau_1 - f_2 \times \tau_2$, in order to compute, in step G, a power spectrum of said signal of interest.

Figure 1

Figure 2

Figure 3

Figure 4

Figure 5

Figure 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Coherent multi-heterodyne spectroscopy using acousto-optic frequency combs. **DURAN V et al.** ARXIV.ORG. CORNELL UNIVERSITY LIBRARY, 20 March 2018
- **CÔME SCHNÉBELIN** ; **HUGUES GUILLET DE CHATELLUS**. Agile photonic fractional Fourier transformation of optical and RF signals. *Optica*, 2017, vol. 4, 907-910
- **CHATELLUS** ; **HUGUES GUILLET** ; **LUIS ROMERO CORTÉS** ; **JOSÉ AZAÑA**. Optical real-time Fourier transformation with kilohertz resolutions. *Optica*, 2016, vol. 3 (1), 1-8
- *Opt. Express*, 2018, vol. 26, 13800-13809